# EUROPEAN PATENT SPECIFICATION

(11) **EP 2 219 222 B1**
(45) Date of publication and mention of the grant of the patent: **03.04.2019**
(21) Application number: 10001157.6
(22) Date of filing: 04.02.2010
(51) Int. Cl.: H01L 27/142, H01L 31/0236, H01L 31/0216

(54) **Solar cell and method for manufacturing the same**
Solarzelle und Verfahren zu ihrer Herstellung
Cellule solaire et son procédé de fabrication

(30) Priority: 04.02.2009 KR 20090008840
(43) Date of publication of application: 18.08.2010
(73) Proprietor: LG ELECTRONICS INC., Yeongdeungpo-gu Seoul 150-721 (KR)
(72) Inventor: Ji, Kwangsun, Seoul, 137-130 (KR); Lee, Heonmin, Seoul, 137-130 (KR); Choi, Junghoon, Seoul, 137-130 (KR); Ahn, Sehwon, Seoul, 137-130 (KR)
(74) Representative: Katérle, Axel

(56) References cited:
- WO-A1-03/083955
- WO-A2-2008/037658
- US-A1- 2008 000 522

## Description

### BACKGROUND OF THE INVENTION

### Field of the Invention

Embodiments of the invention relate to a solar cell and a method for manufacturing the same.

### Description of the Related Art

Recently, as existing energy sources such as petroleum and coal are expected to be depleted, interests in alternative energy sources for replacing the existing energy sources are increasing. Among the alternative energy sources, solar cells generating electric energy from solar energy have been particularly spotlighted.

A silicon solar cell generally includes a substrate and an emitter layer, each of which is formed of a semiconductor, and a plurality of electrodes respectively formed on the substrate and the emitter layer. The semiconductors forming the substrate and the emitter layer have different conductive types, such as a p-type and an n-type. A p-n junction is formed at an interface between the substrate and the emitter layer.

When light is incident on the solar cell, a plurality of electron-hole pairs are generated in the semiconductors. The electron-hole pairs are separated into electrons and holes by the photovoltaic effect. Thus, the separated electrons move to the n-type semiconductor (e.g., the emitter layer) and the separated holes move to the p-type semiconductor (e.g., the substrate), The electrons and holes are respectively collected by the electrodes electrically connected to the emitter layer and the electrodes electrically connected to the substrate. The electrodes are connected to one another using electric wires to thereby obtain electric power.

However, in the solar cell, because the electrodes are formed on the emitter layer on an incident surface of the substrate, on which light is incident, as well as a non-incident surface of the substrate, on which light is not incident, an incident area of light decreases. Hence, efficiency of the solar cell is reduced.

Accordingly, a back contact solar cell, in which all of electrodes collecting electrons and holes were formed on a back surface of a substrate, was developed so as to increase the incident area of light.

From US 2008/0000522 A1 a solar cell device comprising a substrate, an amorphous silicon layer covering the surface facing the light incident direction as well as a transparent anti-reflection layer covering the amorphous silicon layer is known. On the substrate back surface there are provided two semiconductor layers constituting components of device electrodes that are arranged spaced apart from each other and that are both compositionally graded, in terms of dopant concentration.

WO 2008/037658 A2 discloses a solar cell device comprising a substrate which is covered on one surface (the front surface) with an amorphous silicon layer and an anti-reflection layer. The substrate surface and the overlying anti-reflection layer reveal a rippled surface structure.

WO 03/083955 A1 discloses a photovoltaic element comprising a silicon substrate which is covered on the light incident surface side with an anti-reflection layer. On the rear surface of the substrate there are provided P-N junctions and electrodes.

### SUMMARY OF THE INVENTION

A solar cell according to the present invention is defined in claim 1. A method for manufacturing a solar cell according to the present invention is defined in claim 9. Preferred features are defined in the dependent claims. In one aspect useful for understanding the invention, there is a solar cell including a substrate of a first conductive type, an anti-reflection layer positioned on the substrate, the anti-reflection layer being formed of a transparent conductive oxide material, a plurality of emitter layers positioned on the substrate, the plurality of emitter layers being of a second conductive type opposite the first conductive type, a plurality of first electrodes positioned on the plurality of emitter layers, and a plurality of second electrodes that are electrically connected to the substrate and are positioned to be spaced apart from the plurality of first electrodes, wherein the first electrodes and the second electrodes are positioned on the same surface of the substrate.

The transparent conductive oxide material may be at least one selected from the group consisting of indium tin oxide (ITO), Sn-based oxide, Zn-based oxide, and a combination thereof.

The solar cell may further include a first passivation layer positioned on the substrate.

The solar cell may further include a second passivation layer positioned on a surface of the substrate on which the first passivation layer is not positioned.

The second passivation layer may be formed entirely on the surface of the substrate.

The plurality of emitter layers and the plurality of second electrodes may be positioned on portions of the second passivation layer.

The solar cell may further include a plurality of insulating portions positioned on exposed portions of the second passivation layer between the first electrodes and the second electrodes.

The second passivation layer may be formed partially on portions of the surface of the substrate. The plurality of emitter layers and the plurality of second electrodes may be positioned on formed portions of the second passivation layer.

The solar cell may further include a plurality of back surface field layers positioned between the second passivation layer and the plurality of second electrodes.

The solar cell may further include a plurality of insulating portions positioned on exposed portions of the substrate between the plurality of first electrodes and the plurality of second electrodes.

The anti-reflection layer may be positioned on the first passivation layer. A surface of the anti-reflection layer may have a plurality of uneven portions.

The anti-reflection layer may be positioned on an incident surface of the substrate on which light is incident. The plurality of first electrodes and the plurality of second electrodes may be positioned on a surface of the substrate opposite the incident surface.

In one aspect useful for understanding the invention, there is a method for manufacturing a solar cell including forming a first passivation layer on a substrate of a first conductive type at a first temperature, forming an anti-reflection layer on the substrate at a second temperature almost equal to or lower than the first temperature, forming a plurality of doping portions of a second conductive type opposite the first conductive type on first portions of the substrate, and forming a plurality of first electrodes on the plurality of doping portions and forming a plurality of second electrodes on second portions of the substrate.

The anti-reflection layer may be formed of a transparent conductive oxide material. The transparent conductive oxide material may be at least one selected from the group consisting of indium tin oxide (ITO), Sn-based oxide, Zn-based oxide, and a combination thereof.

The method may further include forming a second passivation layer on a surface opposite a surface of the substrate on which the first passivation layer is formed.

The method may further include forming a plurality of back surface field layers between the second portions of the substrate and the plurality of second electrodes so that the plurality of back surface field layers are spaced apart from the plurality of doping portions.

The forming of the second passivation layer may include the second passivation layer being formed under the plurality of doping portions and the plurality of back surface field layers.

The method may further include forming a plurality of insulating portions between the plurality of first electrodes and the plurality of second electrodes.

The method may further include etching a surface of the anti-reflection layer.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a partial cross-sectional view of a solar cell according to an example useful for understanding the invention;
FIGS. 2A to 2I are cross-sectional views sequentially illustrating each of stages in a method for manufacturing a solar cell according to an example useful for understanding the invention;
FIG. 3 is a partial cross-sectional view of a solar cell according to another example useful for understanding the invention;
FIG. 4 is a partial cross-sectional view of a solar cell according to another example useful for understanding invention;
FIG. 5 is a partial cross-sectional view of a solar cell according to an embodiment of the invention;
FIG. 6 is a diagram photographing a partial surface of an anti-reflection layer obtained after texturing the anti-reflection layer of the solar cell shown in FIG. 5; and
FIGS. 7A and 7B illustrate a portion of stages in a method for manufacturing the solar cell shown in FIG. 5.

### DETAILED DESCRIPTION OF THE EMBODIMENTS

The embodiments of the invention will be described more fully hereinafter with reference to the accompanying drawings, in which example embodiments of the invention are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

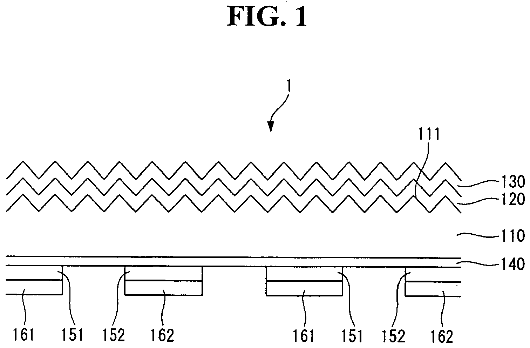

FIG. 1 is a partial cross-sectional view of a solar cell according to an example useful for understanding the invention.

As shown in FIG. 1, a solar cell 1 according to an example useful for understanding the invention includes a substrate 110, a front passivation layer 120 positioned on a surface (hereinafter, referred to as "an incident surface" or "a front surface") of the substrate 110 on which light is incident, an anti-reflection layer 130 on the front passivation layer 120, a back passivation layer 140 positioned on a surface (hereinafter, referred to as "a back surface") of the substrate 110, opposite the front surface of the substrate 110, on which the light is not incident, a plurality of emitter layers 151 on the back passivation layer 140, a plurality of back surface field (BSF) layers 152 on the back passivation layer 140, a plurality of first electrodes 161 respectively positioned on the plurality of emitter layers 151, and a plurality of second electrodes 162 respectively positioned on the plurality of BSF layers 152.

The substrate 110 is a semiconductor substrate formed of a first conductive type silicon, for example, an n-type silicon, though not required. Silicon used in the substrate 110 is crystalline silicon, such as single crystal silicon and polycrystalline silicon. If the substrate 110 is of the n-type, the substrate 110 may contain impurities of a group V element such as phosphorus (P), arsenic (As), and antimony (Sb). Alternatively, the substrate 110 may be of a p-type. If the substrate 110 is of the p-type, the substrate 110 may contain impurities of a group III element such as boron (B), gallium (Ga), and indium (In). In addition, the substrate 110 may be formed of semiconductor materials other than silicon.

The front surface of the substrate 110 is textured to form a textured surface having a plurality of uneven portions 111. Hence, a light reflectance of the front surface of the substrate 110 is reduced. Further, because a light incident operation and a light reflection operation are performed many times on the uneven portions 111 having a pyramid structure, the light is confined in the solar cell 1. Hence, a light absorption increases, and thus the efficiency of the solar cell 1 is improved.

The uneven portions 111 may have a non-uniform pyramid structure, and a height of each of the uneven portions 101 may be approximately 1 *µ*m to 20 *µ*m.

The front passivation layer 120 on the front surface of the substrate 110 having the uneven portions 111 convert defects, such as a dangling bond, existing around the surface of the substrate 110 into stable bonds to thereby prevent or reduce a recombination and/or a disappearance of carriers (e.g., electrons) moving to the front surface of the substrate 110. The front passivation layer 120 is formed of a non-conductive material. Examples of the non-conductive material include amorphous silicon (a-Si), silicon dioxide (SiO₂), and amorphous silicon dioxide (a-SiO₂).

In the embodiment, the front passivation layer 120 has a single-layered structure. However, the front passivation layer 120 may have a multi-layered structure such as a double-layered structure and a triple-layered structure.

The anti-reflection layer 130 on the front passivation layer 120 is used to reduce a reflection loss of the light incident on the solar cell 1. The anti-reflection layer 130 is formed of a transparent conductive oxide material, that has electrical conductivity and transparency and is treated at a temperature equal to or lower than a process temperature of at least one of the front passivation layer 120 and the back passivation layer 140.

The anti-reflection layer 130 may be formed of at least one selected from the group consisting of indium tin oxide (ITO), Sn-based oxide (for example, SnO₂), Zn-based oxide (for example, ZnO, ZnO:Al, and ZnO:B), and a combination thereof. The surface reflection of the anti-reflection layer 130 may be minimized by adjusting a refractive index and a thickness of the anti-reflection layer 130. In the embodiment, the anti-reflection layer 130 may have a refractive index of about 1.8 to 2.1 with respect to light having a wavelength of about 550 nm and may have a thickness of about 80 nm to 100 nm.

Carriers produced in the substrate 110 is prevented from moving to the anti-reflection layer 130 because of the front passivation layer 120 formed of the non-conductive material positioned between the substrate 110 and the anti-reflection layer 130 formed of the conductive oxide material. Further, the front passivation layer 120 prevents or reduces the recombination and/or the disappearance of carriers resulting from the defects as described above.

The back passivation layer 140 on the entire back surface of the substrate 110 is formed of a non-conductive material such as amorphous silicon (a-Si), silicon dioxide (SiO₂), and amorphous silicon dioxide (a-SiO₂) in the same manner as the front passivation layer 120. The back passivation layer 140 converts unstable bonds existing around the surface of the substrate 110 into stable bonds to thereby prevent or reduce a recombination and/or a disappearance of carriers moving to the back surface of the substrate 110. Further, the back passivation layer 140 prevents a current leakage phenomenon caused between the first and second electrodes 161 and 162 through the substrate 110.

The back passivation layer 140 has a very small thickness equal to or less than about 10 nm. Hence, even if the back passivation layer 140 is formed of the non-conductive material, the back passivation layer 140 does not adversely affect a movement of carriers to the first and second electrodes 161 and 162.

In the example, the back passivation layer 140 has a single-layered structure in the same manner as the front passivation layer 120. However, the back passivation layer 140 may have a multi-layered structure such as a double-layered structure and a triple-layered structure.

The plurality of emitter layers 151 on the back passivation layer 140 are spaced apart from one another and extend substantially parallel to one another in a fixed direction. Each of the emitter layers 151 is a semiconductor of a second conductive type opposite the first conductive type of the substrate 110, and is formed of a different semiconductor (for example, amorphous silicon (a-Si)) from the substrate 110. Hence, the emitter layers 151 and the substrate 110 form a heterojunction as well as a p-n junction.

When the emitter layers 151 are of a p-type, the emitter layers 151 may contain impurities of a group III element such as B, Ga, and In. In contrast, when the emitter layers 151 are of an n-type, the emitter layers 151 may contain impurities of a group V element such as P, As, and Sb.

The plurality of BSF layers 152 on the back passivation layer 140 are separated from the emitter layers 151 and extend substantially parallel to one another in the same direction as an extending direction of the emitter layers 151. Thus, as shown in FIG. 1, the plurality of emitter layers 151 and the plurality of BSF layers 152 are alternately positioned on the back surface of the substrate 110.

Each of the plurality of BSF layers 152 is formed of a-Si and is an impurity region that is more heavily doped with impurities of the same conductive type as the substrate 110 than the substrate 110. Hence, holes passing through the back passivation layer 140 are prevented from moving to the second electrodes 162 by a potential barrier resulting from a difference between impurity doping concentrations of the substrate 110 and the BSF layers 152. As a result, a recombination and/or a disappearance of electrons and holes around the second electrodes 162 are prevented or reduced.

A plurality of electron-hole pairs produced by light incident on the substrate 110 are separated into electrons and holes by a built-in potential difference resulting from the p-n junction formed between the substrate 110 and the emitter layers 151. Then, the separated electrons move to the n-type semiconductor, and the separated holes move to the p-type semiconductor. Thus, when the substrate 110 is of the n-type and the emitter layers 151 are of the p-type in the embodiment of the invention, the separated holes pass through the back passivation layer 140 to move to the emitter layers 151 and the separated electrons pass through the back passivation layer 140 to move to the BSF layers 152 having the higher impurity doping concentration than the substrate 110.

Because the substrate 110 and the emitter layers 151 form the p-n junction, the emitter layers 151 are of the n-type when the substrate 110 is of the p-type unlike the embodiment of the invention described above. In this case, the separated electrons pass through the back passivation layer 140 to move to the emitter layers 151, and the separated holes pass through the back passivation layer 140 to move to the BSF layers 152.

Each of the plurality of first electrodes 161 is electrically connected to the emitter layer 151 underlying each first electrode 161, and each of the plurality of second electrodes 162 is electrically connected to the BSF layer 152 underlying each second electrode 162. Each of the first electrodes 161 has the same plane shape as the emitter layer 151 underlying each first electrode 161, but is not limited thereto. Each of the second electrodes 162 has the same plane shape as the BSF layer 152 underlying each second electrode 162, but is not limited thereto. A width of at least one of the first and second electrodes 161 and 162 may be less or greater than a width of at least one of the emitter layer 151 and the BSF layer 152. Each of the first electrodes 161 collects holes moving through the emitter layer 151 underlying each first electrode 161 to output the holes to the outside. Each of the second electrodes 162 collects electrons moving through the BSF layer 152 underlying each second electrode 162 to output the electrons to the outside.

The first and second electrodes 161 and 162 are formed of at least one conductive metal material. Examples of the conductive metal material include at least one selected from the group consisting of nickel (Ni), copper (Cu), silver (Ag), aluminum (Al), tin (Sn), zinc (Zn), indium (In), titanium (Ti), gold (Au), and a combination thereof. Other conductive metal materials may be used.

The solar cell 1 according to the example useful for understanding the invention having the above-described structure is a solar cell in which the first electrodes 161 and the second electrodes 162 are positioned on the back surface of the substrate 110, on which light is not incident, and the substrate 110 and the emitter layer 151 are formed of different semiconductors. An operation of the solar cell 1 is described below.

When light irradiated to the solar cell 1 is incident on the substrate 110 through the anti-reflection layer 130 and the front passivation layer 120, a plurality of electron-hole pairs are generated in the substrate 110 by light energy based on the incident light. Because the front surface of the substrate 110 is the textured surface, a light reflectance in the front surface of the substrate 110 is reduced. Further, because both a light incident operation and a light reflection operation are performed on the textured surface of the substrate 110, a light absorption increases and the efficiency of the solar cell 1 is improved. In addition, because a reflection loss of the light incident on the substrate 110 is reduced by the anti-reflection layer 130, an amount of light incident on the substrate 110 further increases.

The electron-hole pairs are separated from one another by the p-n junction of the substrate 110 and the emitter layers 151, and the separated holes pass through the back passivation layer 140 to move to the p-type emitter layers 151 and the separated electrons pass through the back passivation layer 140 to move to the n-type BSF layers 152. Then, the holes moving to the p-type emitter layers 151 are collected by the first electrodes 161 electrically connected to the p-type emitter layers 151, and the electrons moving to the n-type BSF layers 152 are collected by the second electrodes 162 electrically connected to the n-type BSF layers 152. When the first electrodes 161 are connected to the second electrodes 162 using electric wires, current flows therein to thereby enable use of the current for electric power.

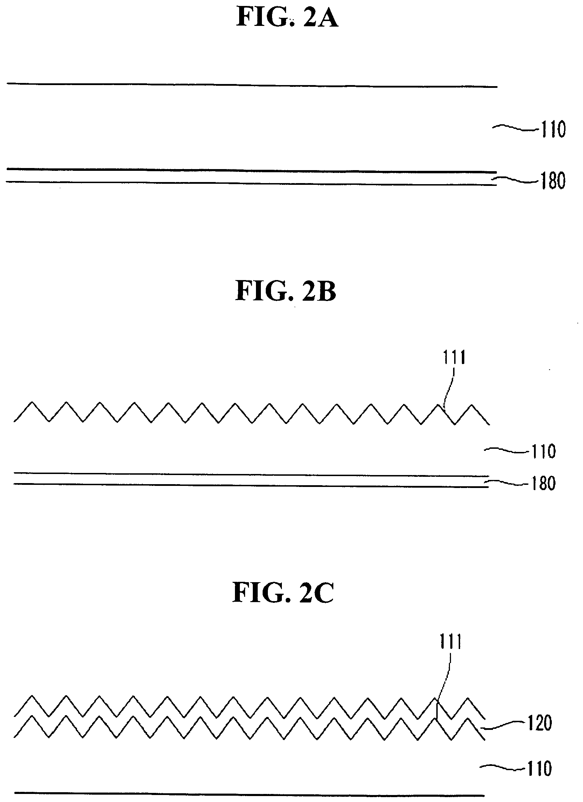

A method for manufacturing the solar cell 1 according to the example useful for understanding the invention is explained below with reference to FIGS. 2A to 2I. FIGS. 2A to 2I are cross-sectional views sequentially illustrating each of stages in a method for manufacturing a solar cell according to an embodiment of the invention.

First, as shown in FIG. 2A, an oxide layer, such as a silicon dioxide (SiO₂) layer, is grown on the back surface of the substrate 110 formed of n-type single crystal silicon or n-type polycrystalline silicon at a high temperature to form an anti-texturing layer 180.

Next, as shown in FIG. 2B, a texturing process is performed on the front surface of the substrate 110, on which light is incident, not having the anti-texturing layer 180 using the anti-texturing layer 180 as a mask to form the plurality of uneven portions 111 on the front surface of the substrate 110. Then, the anti-texturing layer 180 is removed. An alkali solution is used in the texturing process.

For example, the texturing process may be performed in an alkali solution of about 80 °C for about 20 to 40 minutes. In the texturing process, the back surface of the substrate 110 is protected from the alkali solution by the anti-texturing layer 180 and is not etched, and only the front surface of the substrate 110 not having the anti-texturing layer 180 is etched to form the uneven portions 111 having a non-uniform pyramid structure. A reason why the uneven portions 111 are formed on the front surface of the substrate 110 through the texturing process is that an etch rate varies depending on a crystal orientation of the substrate 110. In this case, because the anti-texturing layer 180 formed of silicon dioxide (SiO₂) has an etching resistance to the alkali solution, the anti-texturing layer 180 is not etched in the alkali solution.

A height of each of the uneven portions 111, i.e., a height of the pyramid structure may be approximately 1 *µ*m to 20 *µ*m.

Next, as shown in FIG. 2C, the front passivation layer 120 is formed on the textured front surface of the substrate 110 using a chemical vapor deposition (CVD) method or a sputtering method, etc. The front passivation layer 120 is formed of a non-conductive material such as amorphous silicon (a-Si), silicon dioxide (SiO₂), and amorphous silicon dioxide (a-SiO₂). The front passivation layer 120 may be formed at about 200 °C.

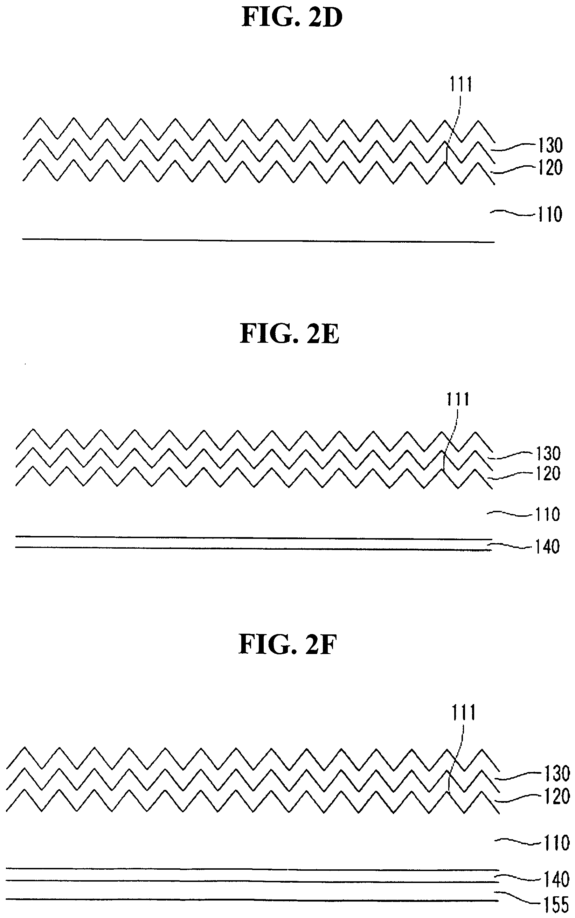

Next, as shown in FIG. 2D, the anti-reflection layer 130 is formed on the front passivation layer 120 using the CVD method or the sputtering method, etc. The anti-reflection layer 130 is formed of a transparent conductive oxide material selected from the group consisting of ITO, Sn-based oxide (for example, SnO₂), Zn-based oxide (for example, ZnO, ZnO:Al, and ZnO:B), and a combination thereof. A formation process of the anti-reflection layer 130 is performed at 200 °C almost equal to a process temperature of the front passivation layer 120 underlying the anti-reflection layer 130. Further, the anti-reflection layer 130 may have a refractive index of about 1.8 to 2.1 with respect to light having a wavelength of about 550 nm.

If the anti-reflection layer 130 is formed of silicon nitride (SiNx), a formation process of the anti-reflection layer 130 may be performed at about 400 °C higher than the process temperature (i.e., about 200 °C) of the front passivation layer 120. Thus, the anti-reflection layer 130 adversely affects the already formed front passivation layer 120 underlying the anti-reflection layer 130. In other words, if the anti-reflection layer 130 is formed at a temperature higher than a process temperature of an already formed layer (for example, the front passivation layer 120), an amorphous material of the front passivation layer 120 may be crystallized or an element coupling state of the front passivation layer 120 may change. Hence, characteristics of the front passivation layer 120 may change. Further, if the anti-reflection layer 130 is formed using a plasma CVD method, a portion of an already formed layer (for example, the front passivation layer 120) may be damaged because of produced plasma.

After all, if the anti-reflection layer 130 is formed at a temperature higher than a formation temperature of the front passivation layer 120, the already formed front passivation layer 120 may be adversely affected by the high temperature, and thus the characteristics of the front passivation layer 120 may worsen.

However, because the anti-reflection layer 130 is formed of the transparent conductive oxide material in the embodiment of the invention, the anti-reflection layer 130 is formed at about 200 °C that is much lower than about 400 °C and is almost equal to the process temperature of the front passivation layer 120. Thus, changes in the characteristics of the front passivation layer 120 resulting from the high temperature are not caused.

Next, as shown in FIG. 2E, the back passivation layer 140 is formed on the back surface of the substrate 110 using the CVD method or the sputtering method, etc. The back passivation layer 140 is formed of a non-conductive material such as amorphous silicon (a-Si), silicon dioxide (SiO₂), and amorphous silicon dioxide (a-SiO₂) in the same manner as the front passivation layer 120. The back passivation layer 140 may be formed at about 200 °C.

The anti-reflection layer 130 may be formed of a material that may be treated at a temperature equal to or lower than a process temperature of at least one of the front passivation layer 120 and the back passivation layer 140 while performing an anti-reflection function, in addition to the transparent conductive oxide material.

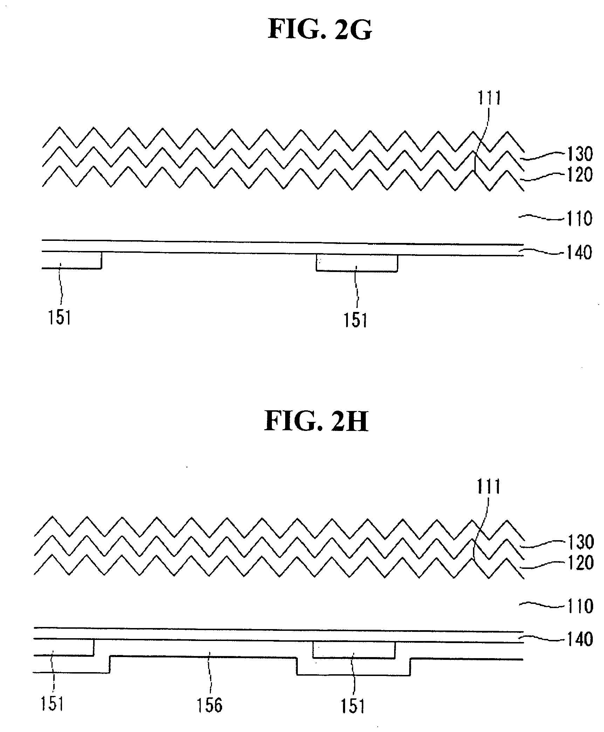

Next, as shown in FIG. 2F, a first impurity layer 155 obtained by doping amorphous silicon (a-Si) with impurities of a group III element such as B, Ga, and In as a dopant is stacked on the entire surface of the back passivation layer 140 using the CVD method or the sputtering method, etc. Then, as shown in FIG. 2G, desired portions of the first impurity layer 155 are removed using, for example, a photosensitive layer (not shown) as an etch mask to form the plurality of emitter layers 151 of a conductive type (e.g., a p-type) opposite a conductive type (e.g., an n-type) of the substrate 110 on the back passivation layer 140. The plurality of emitter layers 151 and the substrate 110 form a p-n junction. The emitter layers 151 may also be referred to as doping portions.

In an alternative embodiment, Si-based paste containing impurities of a group III element may be directly printed on corresponding portions of the back passivation layer 140 using, for example, a screen printing method and then may be thermally treated to form the plurality of emitter layers 151. Alternatively, the emitter layers 151 may be formed by stacking the Si-based paste on desired portions of the back passivation layer 140 using a mask.

Next, as shown in FIG. 2H, a second impurity layer 156 obtained by heavily doping amorphous silicon (a-Si) with impurities of a group V element such as P, As, and Sb as a dopant is formed on the emitter layers 151 and exposed portions of the back passivation layer 140 using the CVD method or the sputtering method, etc.

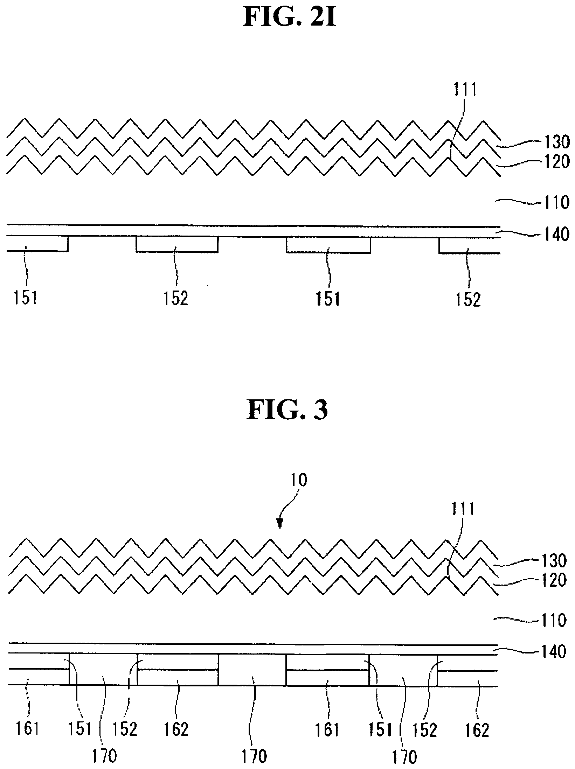

Next, as shown in FIG. 2I, only desired portions of the second impurity layer 156 remain and other portions of the second impurity layer 156 are removed using, for example, an etch mask. Hence, the plurality of BSF layers 152 of the same conductive type (e.g., the n-type) as the substrate 110 is formed on the back passivation layer 140. In this case, a thickness of each of the BSF layers 152 may be different from a thickness of each of the emitter layers 151. For example, the thickness of the BSF layer 152 may be greater or less than the thickness of the emitter layer 151.

In an alternative embodiment, the plurality of BSF layers 152 may be directly stacked only on desired portions of the back passivation layer 140 using the screen printing method or a mask in the same manner as the emitter layers 151.

Unlike the embodiment of the invention, if the substrate 110 is formed of a p-type semiconductor, the n-type emitter layers 151 may be formed using impurities of a group V element as a dopant and the p-type BSF layers 152 may be formed using impurities of a group III element as a dopant.

Afterwards, the first electrodes 161 and a conductive metal material are respectively stacked on the emitter layers 151 and the BSF layers 152 using the screen printing method or a deposition method, etc., to form the first electrodes 161 and the second electrodes 163. Hence, the solar cell 1 shown in FIG. 1 is completed. The conductive metal material may be at least one selected from the group consisting of nickel (Ni), copper (Cu), silver (Ag), aluminum (Al), tin (Sn), zinc (Zn), indium (In), titanium (Ti), gold (Au), and a combination thereof.

In the example useful for understanding the invention, the process for texturing the front surface of the substrate 110, the process for forming the front passivation layer 120 and the anti-reflection layer 130, and the process for forming the back passivation layer 140 are sequentially performed in the order named. However, the process for texturing the front surface of the substrate 110, the process for forming the back passivation layer 140, and the process for forming the front passivation layer 120 and the anti-reflection layer 130 may be sequentially performed in the order named. In this case, the front passivation layer 120 and the back passivation layer 140 have been already formed before forming the anti-reflection layer 130. Because the process temperature of the anti-reflection layer 130 is almost equal to the process temperatures of the front and back passivation layers 120 and 140 as described above, the anti-reflection layer 130 does not affect changes in the characteristics of the front and back passivation layers 120 and 140. Alternatively, after the front and back passivation layers 120 and 140 are formed on the substrate 110, the emitter layers 151, the BSF layers 152, and at least one of the first and second electrodes 161 and 162 may be formed. Then, the anti-reflection layer 130 may be formed.

A solar cell 10 according to another example useful for understanding the invention is described with reference to FIG. 3.

FIG. 3 is a partial cross-sectional view of a solar cell according to another embodiment of the invention. In the following explanations, structural elements having the same functions and structures as those illustrated in FIG. 1 are designated by the same reference numerals, and a further description may be briefly made or may be entirely omitted.

The solar cell 10 shown in FIG. 3 has a structure similar to the solar cell 1 shown in FIG. 1.

More specifically, as shown in FIG. 3, the solar cell 10 according to the example useful for understanding the invention includes a front passivation layer 120 positioned on a front surface of a substrate 110 having a plurality of uneven portions 111, an anti-reflection layer 130 on the front passivation layer 120, a back passivation layer 140 on a back surface of the substrate 110, a plurality of emitter layers 151 that are positioned on the back passivation layer 140 to be spaced apart from one another, a plurality of BSF layers 152 that are positioned on the back passivation layer 140 to be spaced apart from one another, a plurality of first electrodes 161 respectively positioned on the emitter layers 151, and a plurality of second electrodes 162 respectively positioned on the BSF layers 152. The anti-reflection layer 130 may be formed of a transparent conductive oxide material in the same manner as the solar cell 1 shown in FIG.

Unlike the solar cell 1 shown in FIG. 1, the solar cell 10 shown in FIG. 3 further includes a plurality of insulating portions 170 between the emitter layers 151 and the first electrodes 161 underlying the emitter layers 151 and the BSF layers 152 and the second electrodes 162 underlying the BSF layers 152. Each of the insulating portions 170 is formed of a non-conductive material having very low electrical conductivity. Thus, the insulating portions 170 may be formed of the same material as the back passivation layer 140. For example, the insulating portions 170 may be formed of a-Si, SiNx, a-SiNx, SiO₂, a-SiO₂, TiO, non-conducting polymer, etc.

The insulating portions 170 prevent a current leakage phenomenon caused between the emitter layers 151 and the first electrodes 161 and the BSF layers 152 and the second electrodes 162, and thus the solar cell 10 shown in FIG. 3 has higher efficiency than the solar cell 1 shown in FIG. 1.

In a method for manufacturing the solar cell 10 shown in FIG. 3, processes performed up until the formation of the first and second electrodes 161 and 162 are the same as FIGS. 2A to 2H, and thus the description will begin with a subsequent process. After the first and second electrodes 161 and 162 are formed, the insulating portions 170 are formed on desired portions of the back passivation layer 140 using a screen printing method. Hence, the solar cell 10 is completed.

Alternatively, the insulating portions 170 may be formed on desired portions of the back passivation layer 140 using a spin coating method, a CVD method, or a sputtering, etc.

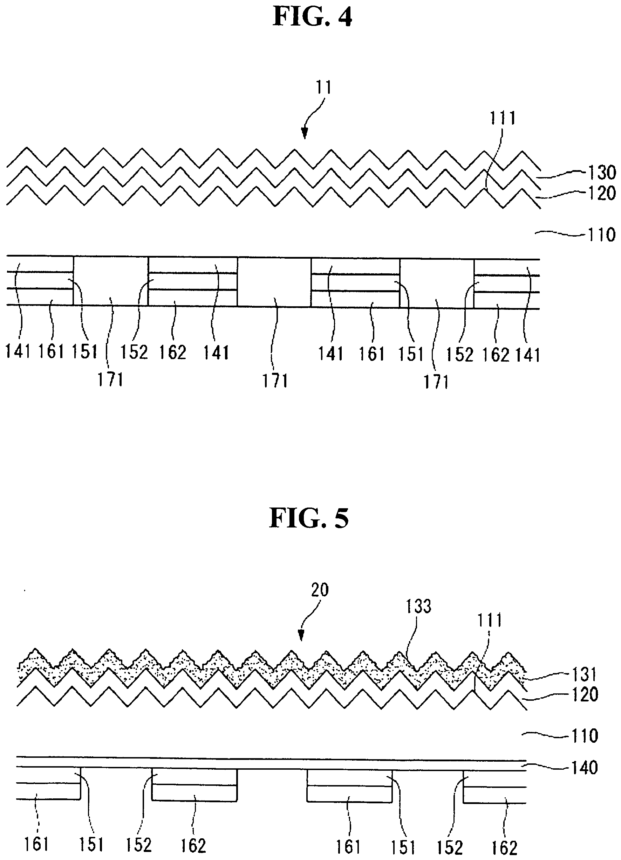

A solar cell 11 according to another embodiment of the invention is described with reference to FIG. 4.

FIG. 4 is a partial cross-sectional view of a solar cell according to another example useful for understanding the invention. In the following explanations, structural elements having the same functions and structures as those illustrated in FIGS. 1 and 3 are designated by the same reference numerals, and a further description may be briefly made or may be entirely omitted.

The solar cell 11 shown in FIG. 4 has a structure similar to the solar cell 10 shown in FIG. 3.

More specifically, as shown in FIG. 4, the solar cell 11 according to the example useful for understanding the invention includes a front passivation layer 120 positioned on a front surface of a substrate 110 having a plurality of uneven portions 111, an anti-reflection layer 130 on the front passivation layer 120, a plurality of back passivation layers 141 on a back surface of the substrate 110, a plurality of emitter layers 151 that are respectively positioned on the back passivation layers 141 to be spaced apart from one another, a plurality of BSF layers 152 that are respectively positioned on the back passivation layers 141 to be spaced apart from one another, a plurality of first electrodes 161 respectively positioned on the emitter layers 151, a plurality of second electrodes 162 respectively positioned on the BSF layers 152, and a plurality of insulating portions 171 positioned between the emitter layers 151 and the first electrodes 161 underlying the emitter layers 151 and the BSF layers 152 and the second electrodes 162 underlying the BSF layers 152.

Unlike the solar cell 10 shown in FIG. 3, the back passivation layers 141 of the solar cell 11 shown in FIG. 4 are positioned on not the entire surface of the substrate 110 but portions of the substrate 110. Further, the emitter layers 151 and the BSF layers 152 are positioned only on the back passivation layers 141, and the first electrodes 161 and the second electrodes 162 are positioned on the emitter layers 151 and the BSF layers 152. Hence, the insulating portions 171 of the solar cell 11 shown in FIG. 4 are formed on the substrate 110, unlike the insulating portions 170 of the solar cell 10 shown in FIG. 3 that are formed on the back passivation layer 140 exposed between the emitter layers 151 and the first electrodes 161 and the BSF layers 152 and the second electrodes 162. The insulating portions 171 are formed of a non-conductive material in the same manner as the insulating portions 170 shown in FIG. 3.

The plurality of insulating portions 171 may be formed through the following methods. First, as shown in FIGS. 2A to 2I, the back passivation layer is formed on the entire back surface of the substrate 110, and then the plurality of emitter layers 151 and the plurality of BSF layers 152 are formed on corresponding portions of the back passivation layer. Then, the plurality of first electrodes 161 are respectively formed on the emitter layers 151, and the plurality of second electrodes 162 are respectively formed on the BSF layers 152. Then, exposed portions of the back passivation layer that are not covered by the emitter layers 151 and the BSF layers 152 are removed to form the plurality of insulating portions 171. Alternatively, as shown in FIGS. 2A to 2E, the back passivation layer is formed on the entire back surface of the substrate 110, and then portions of the back passivation layer are removed. Then, as shown in FIGS. 2F to 2I, the plurality of emitter layers 151, the plurality of BSF layers 152, the plurality of first electrodes 161, and the plurality of second electrodes 162 are sequentially formed, and then the plurality of insulating portions 171 are formed.

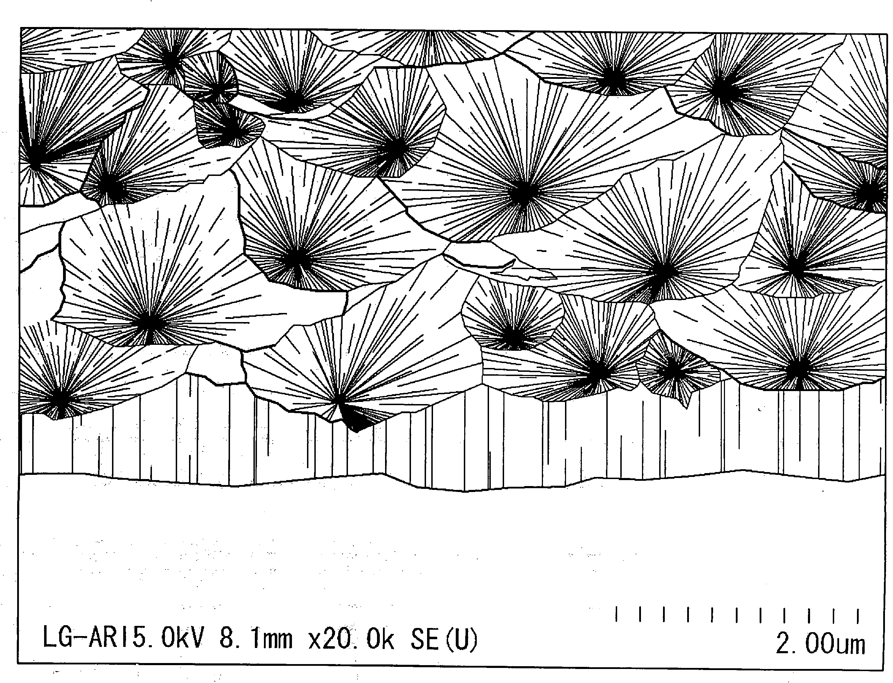

A solar cell 20 according to an embodiment of the invention is described with reference to FIGS. 5 and 6.

FIG. 5 is a partial cross-sectional view of a solar cell according to an embodiment of the invention. FIG. 6 is a diagram photographing a partial surface of an anti-reflection layer obtained after texturing the anti-reflection layer of the solar cell shown in FIG. 5. In the following explanations, structural elements having the same functions and structures as those illustrated in FIG. 1 are designated by the same reference numerals, and a further description may be briefly made or may be entirely omitted.

The solar cell 20 shown in FIG. 5 has a structure similar to the solar cell 1 shown in FIG. 1.

More specifically, as shown in FIG. 5, the solar cell 20 according to the embodiment of the invention includes a front passivation layer 120 positioned on a front surface of a substrate 110 having a plurality of uneven portions 111, an anti-reflection layer 131 on the front passivation layer 120, a back passivation layer 140 on a back surface of the substrate 110, a plurality of emitter layers 151 that are positioned on the back passivation layer 140 to be spaced apart from one another, a plurality of BSF layers 152 that are positioned on the back passivation layer 140 to be spaced apart from one another, a plurality of first electrodes 161 respectively positioned on the emitter layers 151, and a plurality of second electrodes 162 respectively positioned on the BSF layers 152. The anti-reflection layer 131 may be formed of Zn-based oxide such as ZnO, ZnO:Al, and ZnO:B.

Unlike the solar cell 1 shown in FIG. 1, the surface of the anti-reflection layer 131 of the solar cell 20 shown in FIG. 5 is textured. An etching process using an acid solution is used to texture the surface of the anti-reflection layer 131. Hence, the anti-reflection layer 131, as shown in FIG. 6, further has the surface of a plurality of micro-uneven portions 133 formed on the uneven portions 111 as well as the surface of the uneven portions 111 formed on the textured surface of the substrate 110, compared with the anti-reflection layer 130 shown in FIG. 1. In this case, the size of the micro-uneven portions 133 is smaller than the size of the uneven portions 111. As a result, an incident path of light increases, and thus an absorptance of the light is further improved. A texturing level of the surface of the anti-reflection layer 131 may be controlled by adjusting etching time in consideration of characteristics such as a material of the anti-reflection layer 131.

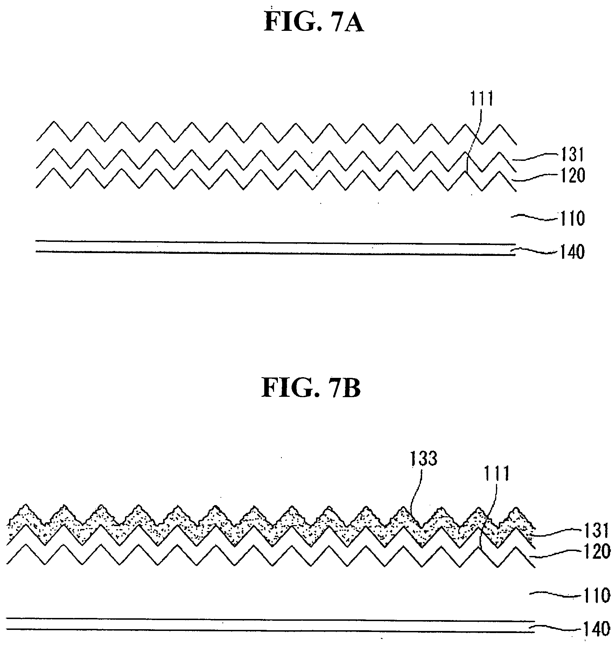

A method for manufacturing the solar cell 20 shown in FIG. 5 is described with reference to FIGS. 2A to 2I as well as FIGS. 7A and 7B.

FIGS. 7A and 7B illustrate a portion of stages in a method for manufacturing the solar cell shown in FIG. 5.

First, as shown in FIGS. 2A to 2C, the back passivation layer140 is formed on the back surface of the substrate 110. After the front surface of the substrate 110 not covered by the back passivation layer 140 is textured, the front passivation layer 120 is formed on the textured front surface of the substrate 110.

Afterwards, as shown in FIG. 7A, the anti-reflection layer 131 formed of Zn-based oxide is formed on the front passivation layer 120 using the sputtering method. The anti-reflection layer 131 may be formed, so that a thickness of the anti-reflection layer 131 is greater than a thickness of the anti-reflection layer 130 shown in FIG. 2D in consideration of an etching degree of the anti-reflection layer 131. Alternatively, the anti-reflection layer 131 may be formed on the front passivation layer 120 using another method such as the CVD method.

Next, the surface of the anti-reflection layer 131 is etched through a wet etching method using an acid solution, and thus the surface of the anti-reflection layer 131 has a plurality of uneven portions 133 finer than the uneven portions 111 obtained by texturing the surface of the substrate 110. In this case, the thickness of the anti-reflection layer 131 is reduced because of the etching process.

After the surface of the anti-reflection layer 131 is etched using the acid solution as described above, the plurality of emitter layers 151, the plurality of BSF layers 152, the plurality of first electrodes 161, and the plurality of second electrodes 162 are sequentially formed as shown in FIGS. 2E to 2I. Hence, the solar cell 20 shown in FIG. 5 is completed.

Although the solar cell 20 shown in FIG. 5 was described using the structure of the solar cell 1 shown in FIG. 1, it is not limited thereto. For example, the solar cell 20 shown in FIG. 5 may be described using the solar cells 10 and 11 respectively shown in FIGS. 3 and 4.

As described above, in the solar cells according to the embodiments of the invention, in case of a back contact solar cell, because a process temperature of an anti-reflection layer formed of a transparent conductive oxide material is lowered, changes in characteristics of another layer, that has been already formed prior to the anti-reflection layer, are prevented or reduced. Hence, an operation efficiency of the back contact solar cell is improved. Furthermore, because the surface of the anti-reflection layer is etched to form a plurality of uneven portions, an amount of incident light increases.

Although the explanation was given of an example of a heterojunction solar cell in the embodiments of the invention, a homojunction solar cell, in which a substrate and an emitter layer are formed of the same kind of semiconductor, may be applied to the embodiments of the invention.

Although the explanation was given of an example of a dual damascene process, an explanation will be given of an example of a single damascene process.

## Claims

1. A solar cell (1), comprising:
a single crystal substrate (110) of a first conductive type having a textured front surface having a plurality of uneven portions (111), wherein the front surface of the single crystal substrate has been textured by an alkali solution;
a second passivation layer (140) on a back surface of the substrate;
a first passivation layer (120) positioned on the textured front surface of the substrate (110);
an anti-reflection layer (130, 131) positioned on the first passivation layer (120),
the anti-reflection layer (130, 131) being formed of a transparent conductive oxide material and having a plurality of uneven portions;
a plurality of emitter layers (151) positioned on the second passivation layer (140), the plurality of emitter layers (151) being of a second conductive type opposite the first conductive type;
a plurality of first electrodes (161) positioned on the plurality of emitter layers (151); and
a plurality of second electrodes (162) that are electrically connected to the substrate (110) and are positioned on the second passivation layer (140) and to be spaced apart from the plurality of first electrodes (161), wherein the first electrodes (161) and the second electrodes (162) are positioned on the same surface of the substrate (110), wherein a plurality of micro-uneven portions (133) are formed on the uneven portions (111) of the anti-reflection layer (130, 131), wherein the micro-uneven portions (133) are formed by etching the anti-reflection layer by a wet etching method using an acid solution.

2. The solar cell (1) of claim 1, wherein the transparent conductive oxide material is at least one selected from the group consisting of indium tin oxide (ITO), Sn-based oxide, Zn-based oxide, and a combination thereof.

3. The solar cell (1) of claim 1, wherein the second passivation layer (140) is formed entirely on the back surface of the substrate (110).

4. The solar cell (1) of claim 3, further comprising a plurality of insulating portions (170) positioned on exposed portions of the second passivation layer (140) between the first electrodes (161) and the second electrodes (162).

5. The solar cell (1) of claim 3 or 4, wherein the second passivation layer (140) is formed partially on portions of the surface of the substrate (110), and the plurality of emitter layers (151) and the plurality of second electrodes (162) are positioned on formed portions of the second passivation layer (140).

6. The solar cell (1) of claim 3 or 5, further comprising a plurality of back surface field layers (152) positioned between the second passivation layer (140) and the plurality of second electrodes (162).

7. The solar cell (1) of claim 5, further comprising a plurality of insulating portions (170) positioned on exposed portions of the substrate (110) between the plurality of first electrodes (161) and the plurality of second electrodes (162).

8. The solar cell (1) of any one preceding claim, wherein the anti-reflection layer (130, 131) is positioned on an incident surface of the substrate (110) on which light is incident, and the plurality of first electrodes (161) and the plurality of second electrodes (162) are positioned on a surface of the substrate (110) opposite the incident surface.

9. A method for manufacturing a solar cell (1) according to claim 1, the method comprising:
texturing a front surface of a single crystal silicon substrate (110) of a first conductive type using an alkali solution, wherein a back surface of the single crystal silicon substrate (110) is covered by a second passivation layer (140);
forming a first passivation layer (120) on the front surface of the textured substrate (110) at a first temperature;
forming an anti-reflection layer (130, 131) on the first passivation layer (120) at a second temperature almost equal to or lower than the first temperature, wherein the anti-reflection layer (130, 131) is formed of a transparent conductive oxide material;
etching a plurality of uneven portions (111) of the anti-reflection layer (130, 131) to form a plurality of micro-uneven portions (133) on the plurality of uneven portions (111) of the anti-reflection layer (130, 131) by a wet etching method using an acid solution;
forming a plurality of doping portions of a second conductive type opposite the first conductive type on first portions of the substrate (110); and
forming a plurality of first electrodes (161) on the plurality of doping portions and forming a plurality of second electrodes (162) on second portions of the substrate (110).

10. The method of claim 9, wherein the transparent conductive oxide material is preferably at least one selected from the group consisting of indium tin oxide (ITO), Sn-based oxide, Zn-based oxide, and a combination thereof.

11. The method of claim 9 or 10, further comprising forming a plurality of insulating portions (170) between the plurality of first electrodes (161) and the plurality of second electrodes (162).

12. The method of claims 9 to 11, further comprising forming a plurality of back surface field layers (152) between the second portions of the substrate (110) and the plurality of second electrodes (162) so that the plurality of back surface field layers (152) are spaced apart from the plurality of doping portions, wherein the second passivation layer (140) is preferably formed under the plurality of doping portions and the plurality of back surface field layers (152).

## Patentansprüche

1. Solarzelle (1), umfassend:
ein Einkristallsubstrat (110) eines ersten Leitfähigkeitstyps mit einer texturierten Vorderseite mit einer Mehrzahl von unebenen Abschnitten (111), wobei die Vorderseite des Einkristallsubstrats durch eine alkalische Lösung texturiert worden ist;
eine zweite Passivierungsschicht (140) auf einer Rückseite des Substrats;
eine erste Passivierungsschicht (120), die auf der texturierten Vorderseite des Substrats (110) angeordnet ist;
eine Antireflexionsschicht (130, 131), die auf der ersten Passivierungsschicht angeordnet ist, wobei die Antireflexionsschicht (130, 131) aus einem transparenten leitfähigen Oxidmaterial gebildet ist und eine Mehrzahl von unebenen Abschnitten aufweist;
eine Mehrzahl von Emitterschichten (151), die auf der zweiten Passivierungsschicht (140) angeordnet ist, wobei die Mehrzahl von Emitterschichten (151) von einem zweiten Leitfähigkeitstyp ist, der zu dem ersten Leitfähigkeitstyp entgegengesetzt ist;
eine Mehrzahl von ersten Elektroden (161), die auf der Mehrzahl von Emitterschichten (151) angeordnet ist; und
eine Mehrzahl von zweiten Elektroden (162), die elektrisch mit dem Substrat (110) verbunden ist und auf der zweiten Passivierungsschicht (140) angeordnet ist und von der Mehrzahl von ersten Elektroden (161) beabstandet ist, wobei die ersten Elektroden (161) und die zweiten Elektroden (162) auf der gleichen Oberfläche des Substrats (110) angeordnet sind, wobei eine Mehrzahl von mikro-unebenen Abschnitten (133) auf den unebenen Abschnitten (111) der Antireflexionsschicht (130, 131) gebildet ist, wobei die mikro-unebenen Abschnitte (133) durch Ätzen der Antireflexionsschicht in einem Nassätzverfahren unter Verwendung einer sauren Lösung gebildet sind.

2. Solarzelle (1) nach Anspruch 1, wobei das transparente leitfähige Oxidmaterial mindestens eines ausgewählt aus der Gruppe bestehend aus Indiumzinnoxid (ITO), Sn-basiertem Oxid, Zn-basiertem Oxid und einer Kombination davon ist.

3. Solarzelle (1) nach Anspruch 1, wobei die zweite Passivierungsschicht (140) vollständig auf der Rückseite des Substrats (110) gebildet ist.

4. Solarzelle (1) nach Anspruch 3, des Weiteren umfassend eine Mehrzahl von isolierenden Abschnitten (170), die auf exponierten Abschnitten der zweiten Passivierungsschicht (140) zwischen den ersten Elektroden (161) und den zweiten Elektroden (162) angeordnet ist.

5. Solarzelle (1) nach Anspruch 3 oder 4, wobei die zweite Passivierungsschicht (140) teilweise auf Abschnitten der Oberfläche des Substrats (110) gebildet ist, und wobei die Mehrzahl von Emitterschichten (151) und die Mehrzahl von zweiten Elektroden (162) auf gebildeten Abschnitten der zweiten Passivierungsschicht (140) angeordnet sind.

6. Solarzelle (1) nach Anspruch 3 oder 5, des Weiteren umfassend eine Mehrzahl von Rückseiten-Feldschichten (152), die zwischen der zweiten Passivierungsschicht (140) und der Mehrzahl von zweiten Elektroden (162) angeordnet ist.

7. Solarzelle (1) nach Anspruch 5, des Weiteren umfassend eine Mehrzahl von isolierenden Abschnitten (170), die auf exponierten Abschnitten des Substrats (110) zwischen der Mehrzahl von ersten Elektroden (161) und der Mehrzahl von zweiten Elektroden (162) angeordnet ist.

8. Solarzelle (1) nach einem beliebigen der vorhergehenden Ansprüche, wobei die Antireflexionsschicht (130, 131) auf einer Einfallsfläche des Substrats (110), auf welcher Licht einfällt, angeordnet ist und wobei die Mehrzahl von ersten Elektroden (161) und die Mehrzahl von zweiten Elektroden (162) auf einer Oberfläche des Substrats (110), welche der Einfallfläche entgegengesetzt ist, angeordnet sind.

9. Verfahren zum Herstellen einer Solarzelle (1) gemäß Anspruch 1, wobei das Verfahren umfasst:
Texturieren einer Vorderseite eines Einkristall-Siliziumsubstrats (110) eines ersten Leitfähigkeitstyps unter Verwendung einer alkalischen Lösung, wobei eine Rückseite des Einkristall-Siliziumsubstrats (110) durch eine zweite Passivierungsschicht (140) bedeckt ist;
Bilden einer ersten Passivierungsschicht (120) auf der Vorderseite des texturierten Substrats (110) bei einer ersten Temperatur;
Bilden einer Antireflexionsschicht (130, 131) auf der ersten Passivierungsschicht (120) bei einer zweiten Temperatur, welche beinahe gleich zu oder niedriger ist als die erste Temperatur, wobei die Antireflexionsschicht (130, 131) aus einem transparenten leitfähigen Oxidmaterial gebildet wird;
Ätzen einer Mehrzahl von unebenen Abschnitten (111) der Antireflexionsschicht (130, 131), um eine Mehrzahl von mikro-unebenen Abschnitten (133) auf der Mehrzahl von unebenen Abschnitten (111) der Antireflexionsschicht (130, 131) durch ein Nassätzverfahren unter Verwendung einer sauren Lösung zu bilden;
Bilden einer Mehrzahl von dotierten Abschnitten eines zweiten Leitfähigkeitstyps, welcher zu dem ersten Leitfähigkeitstyp entgegengesetzt ist, auf ersten Abschnitten des Substrats (110); und
Bilden einer Mehrzahl von ersten Elektroden (161) auf der Mehrzahl von dotierten Abschnitten und Bilden einer Mehrzahl von zweiten Elektroden (162) auf zweiten Abschnitten des Substrats (110).

10. Verfahren nach Anspruch 9, wobei das transparente leitfähige Oxidmaterial vorzugsweise mindestens eines ausgewählt aus der Gruppe bestehend aus Indiumzinnoxid (ITO), Sn-basiertem Oxid, Zn-basiertem Oxid und einer Kombination davon ist.

11. Verfahren nach Anspruch 9 oder 10, des Weiteren umfassend Bilden einer Mehrzahl von isolierenden Abschnitten (170) zwischen der Mehrzahl von ersten Elektroden (161) und der Mehrzahl von zweiten Elektroden (162).

12. Verfahren nach einem der Ansprüche 9 bis 11, des Weiteren umfassend eine Mehrzahl von Rückseiten-Feldschichten (152) zwischen den zweiten Abschnitten des Substrats (110) und der Mehrzahl von zweiten Elektroden (162), so dass die Mehrzahl von Rückseiten-Feldschichten (152) von der Mehrzahl von dotierten Abschnitten beabstandet ist, wobei die zweite Passivierungsschicht (140) vorzugsweise unter der Mehrzahl von dotierten Abschnitten und der Mehrzahl von Rückseiten-Feldschichten (152) gebildet wird.

## Revendications

1. Cellule solaire (1) comprenant :
un substrat monocristallin (110) d'un premier type conducteur ayant une surface avant texturée présentant une pluralité de parties irrégulières (111), dans lequel la surface avant du substrat monocristallin a été texturée par une solution alcaline ;
une seconde couche de passivation (140) sur une surface arrière du substrat ;
une première couche de passivation (120) positionnée sur la surface avant texturée du substrat (110) ;
une couche antireflet (130, 131) positionnée sur la première couche de passivation (120),
la couche antireflet (130, 131) étant formée d'un matériau d'oxyde conducteur transparent et comportant une pluralité de parties irrégulières ;
une pluralité de couches d'émetteur (151) positionnées sur la seconde couche de passivation (140), la pluralité de couches d'émetteur (151) étant d'un second type conducteur opposé au premier type conducteur ;
une pluralité de premières électrodes (161) positionnées sur la pluralité de couches d'émetteur (151) ; et
une pluralité de secondes électrodes (162) qui sont électriquement connectées au substrat (110) et sont positionnées sur la seconde couche de passivation (140) et doivent être espacées de la pluralité de premières électrodes (161), dans laquelle les premières électrodes (161) et les secondes électrodes (162) sont positionnées sur la même surface du substrat (110), dans laquelle une pluralité de micro-parties irrégulières (133) sont formées sur les parties irrégulières (111) de la couche antireflet (130, 131), dans laquelle les micro-parties irrégulières (133) sont formées par gravure de la couche antireflet par un procédé de gravure humide utilisant une solution acide.

2. Cellule solaire (1) selon la revendication 1, dans laquelle le matériau d'oxyde conducteur transparent est au moins un matériau choisi dans le groupe constitué par l'oxyde d'étain et d'indium (ITO), un oxyde à base de Sn, un oxyde à base de Zn et une combinaison de ceux-ci.

3. Cellule solaire (1) selon la revendication 1, dans laquelle la seconde couche de passivation (140) est entièrement formée sur la surface arrière du substrat (110).

4. Cellule solaire (1) selon la revendication 3, comprenant en outre une pluralité de parties isolantes (170) positionnées sur des parties exposées de la seconde couche de passivation (140) entre les premières électrodes (161) et les secondes électrodes (162).

5. Cellule solaire (1) selon la revendication 3 ou 4, dans laquelle la seconde couche de passivation (140) est formée partiellement sur des parties de la surface du substrat (110), et la pluralité de couches d'émetteur (151) et la pluralité de secondes électrodes (162) sont positionnées sur des parties formées de la seconde couche de passivation (140).

6. Cellule solaire (1) selon la revendication 3 ou 5, comprenant en outre une pluralité de couches de champ de surface arrière (152) positionnées entre la seconde couche de passivation (140) et la pluralité de secondes électrodes (162).

7. Cellule solaire (1) selon la revendication 5, comprenant en outre une pluralité de parties isolantes (170) positionnées sur des parties exposées du substrat (110) entre la pluralité de premières électrodes (161) et la pluralité de secondes électrodes (162).

8. Cellule solaire (1) selon l'une quelconque des revendications précédentes, dans laquelle la couche antireflet (130, 131) est positionnée sur une surface incidente du substrat (110) sur laquelle la lumière est incidente, et la pluralité de premières électrodes (161) et la pluralité de secondes électrodes (162) sont positionnées sur une surface du substrat (110) opposée à la surface incidente.

9. Procédé de fabrication d'une cellule solaire (1) selon la revendication 1, le procédé comprenant :
texturer une surface avant d'un substrat de silicium monocristallin (110) d'un premier type conducteur à l'aide d'une solution alcaline, dans laquelle une surface arrière du substrat de silicium monocristallin (110) est recouverte d'une seconde couche de passivation (140) ;
former une première couche de passivation (120) sur la surface avant du substrat texturé (110) à une première température ;
former une couche antireflet (130, 131) sur la première couche de passivation (120) à une seconde température presque égale ou inférieure à la première température, dans laquelle la couche antireflet (130, 131) est formée d'un matériau d'oxyde conducteur transparent ;
graver une pluralité de parties irrégulières (111) de la couche antireflet (130, 131) pour former une pluralité de micro-parties irrégulières (133) sur la pluralité de parties irrégulières (111) de la couche antireflet (130, 131) par un procédé de gravure humide utilisant une solution acide ;
former une pluralité de parties de dopage d'un second type conducteur opposé au premier type conducteur sur des premières parties du substrat (110) ; et
former une pluralité de premières électrodes (161) sur la pluralité de parties de dopage et former une pluralité de secondes électrodes (162) sur des secondes parties du substrat (110).

10. Procédé selon la revendication 9, dans lequel le matériau d'oxyde conducteur transparent est de préférence au moins un matériau choisi dans le groupe constitué par l'oxyde d'étain et d'indium (ITO), un oxyde à base de Sn, un oxyde à base de Zn et une combinaison de ceux-ci.

11. Procédé selon la revendication 9 ou 10, comprenant en outre :
former une pluralité de parties isolantes (170) entre la pluralité de premières électrodes (161) et la pluralité de secondes électrodes (162).

12. Procédé selon les revendications 9 à 11, comprenant en outre la formation d'une pluralité de couches de champ de surface arrière (152) entre les secondes parties du substrat (110) et la pluralité de secondes électrodes (162) de sorte que la pluralité de couches de champs de surface arrière (152) sont espacées de la pluralité de parties de dopage, dans laquelle la seconde couche de passivation (140) est de préférence formée sous la pluralité de parties de dopage et la pluralité de couches de champ de surface arrière (152).
